Europäisches Patentamt

(19) European Patent Office

Office européen des brevets

(11) Publication number: **0 090 611**

**B1**

# (12) EUROPEAN PATENT SPECIFICATION

(45) Date of publication of patent specification: **14.12.88**

(51) Int. Cl.⁴: **H 01 L 39/24,** H 01 L 39/22

(21) Application number: **83301676.9**

(22) Date of filing: **25.03.83**

(54) Josephson junctions having lead-alloy electrodes.

(30) Priority: **26.03.82 US 362568**

(43) Date of publication of application:
**05.10.83 Bulletin 83/40**

(45) Publication of the grant of the patent:
**14.12.88 Bulletin 88/50**

(84) Designated Contracting States:
**CH DE FR GB IT LI NL**

(56) References cited:
**EP-A-0 013 130**

**JOURNAL OF APPLIED PHYSICS, vol. 49, no. 5, May 1978, pages 2880-2884, American Institute of Physics, New York, US; S.K. LAHIRI et al.: "Lead-alloy Josephson-tunneling gates with improved stability upon thermal cycling"**

**IBM TECHNICAL DISCLOSURE BULLETIN, vol. 18, no. 8, January 1976, page 2646, New York, US; T. FORSTER et al.: "Making Josephson junctions in one vacuum step"**

(73) Proprietor: **SPERRY CORPORATION
1290, Avenue of the Americas
New York, N.Y. 10019 (US)**

(72) Inventor: **Lung-Chung-Young, Peter, Dr.
224 Old Church Road
North Wales Pennsylvania 19454 (US)**

(74) Representative: **Orchard, Oliver John
JOHN ORCHARD & CO. Staple Inn Buildings
North High Holborn
London WC1V 7PZ (GB)**

Courier Press, Leamington Spa, England.

## Description

Josephson junction devices are operated at temperatures in the region of four degrees Kelvin. The circuits embodying such devices need to be repaired and maintained at room temperature, which is approximately three hundred degrees Kelvin, and in the preferred methods of making such devices temperatures of approximately three hundred and seventy degrees Kelvin may occur. It has been found that Josephson junction devices using lead or lead-alloy layers for the electrodes may have a high failure rate in manufacture or may deteriorate rapidly on cycling between operating and room temperatures. This is believed to be due to grain growth in the electrode material as a result of the thermal cycling, the enlargement of the grains causing penetration of the very thin tunnel barrier deposited on the base electrode, and so causing failure of the device. It is an object of the present invention to provide a lead-alloy based Josephson junction device which is resistant to damage by thermal cycling.

An attempt to overcome this difficulty is described by H. C. Ward Huang, IEEE Transactions on Electron Devices, Volume Ed-27, No. 10, October 1980 , pages 1979 to 1987, in which the base electrode materials are deposited at a temperature of seventy seven degrees Kelvin to produce a fine grain structure.

In the present invention as claimed in Claim 1 during the deposition step the vacuum chamber is first evacuated to better than $1.33 \cdot 10^{-4} Pa$ ($10^{-6}$ torr) to remove contaminants such as water vapour and the deposition of the layers forming the base electrode is carried out in an inert gas, such as argon, at a pressure preferably of 2.67 Pa (20 m torr). Josephson junctions so made are found to have a considerable resistance to damage by thermal cycling. The method of the invention will now be described in more detail with reference to the accompanying drawings, in which

Figure 1 is a schematic cross-section of a Josephson junction;

Figure 2 is a diagrammatic section of a vacuum bell-jar system used in the manufacture of Josephson junction devices;

Figures 3A and 3B are enlarged schematic cross-sections of a portion of the deposited base electrode material of Figure 1 respectively before and after annealing;

Figures 4A and 4B are similar sections of the base electrode made by a variation of the process of Figure 3; and

Figure 5 is a graph showing the relationship between pressure and flow rate of the inert gas in the vacuum chamber.

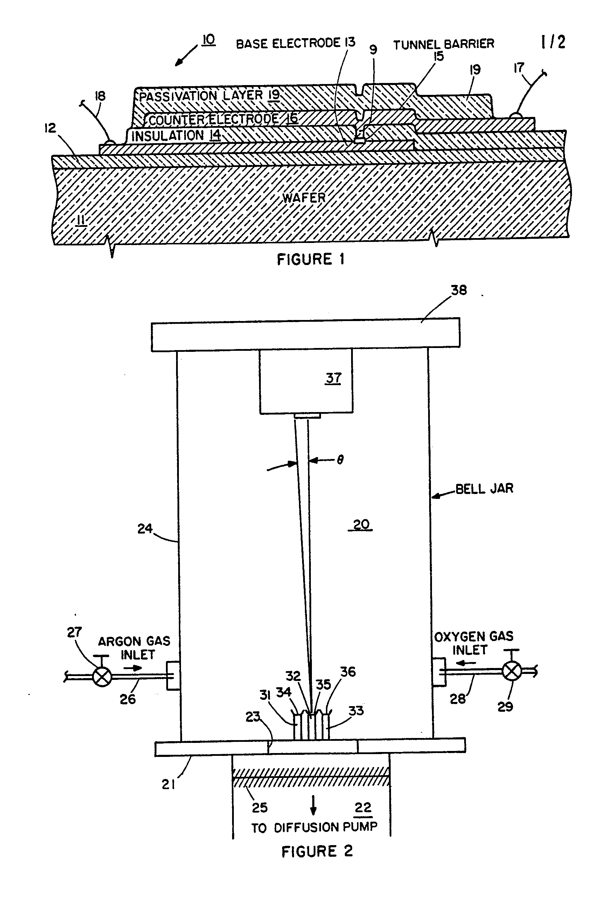

Figure 1 is a cross-section of a typical Josephson junction 10 which may be one of many made on a flat surface, such as a polished silicon wafer 11 to form an integrated circuit using well known semiconductor processing techniques. The silicon wafer 11 is approximately 13 mils (about 330 micro-meters) thick and has thermally-grown silicon dioxide ($SiO_2$) isolation layer 12 formed thereon in a diffusion furnace. The wafer is then placed in a vaccuum chamber and a series of layers are deposited to form the base electrode 13, comprising a layer of lead, a layer of gold and a second layer of some form of superconducting metal such as indium, as will be explained in detail hereinafter. The partially completed junction is removed from the vacuum chamber, a photoresist mask pattern forming a lift-off stencil is applied to the now exposed layers 12 and 13, and it is returned to the vacuum chamber, where a silicon oxide insulation layer 14 is applied over the lift-off stencil. When the substrate is again removed from the vacuum chamber, the photoresist may be removed by standard techniques, leaving an aperture or window 9 in the silicon oxide insulation layer 14. Before returning the partially complete Josephson junction 10 to the vacuum chamber, a second photoresist lift-off stencil is applied which defines the counter electrode. After the partially complete device is returned to the vacuum chamber, the lead oxide and indium oxide tunnel barrier 15 is formed by radio frequency oxidation, which is a well known technique. The tunnel barrier 15 is approximately fifty angstroms (5 nm) thick and is partially embedded in the base electrode 13 and partially grown above the base electrode. For an experimental test junction, the silicon oxide insulation layer 14 may be approximately 3000 angstroms (300 nm) thick. While still in the vacuum chamber, a second, or counter electrode 16, is formed on top of the insulation layer 14 and the tunnel barrier 15. The partially complete Josephson junction 10 is now removed from the vacuum furnace and the lift-off photoresist is stripped away by immersing it in acetone, exposing the counter electrode 16 to which a lead or wire 17 is attached. A second wire lead 18 is attached to the base electrode 13, to form a complete circuit through the tunnel barrier 15. Unless the Josephson junction 10 is only to be used for a limited number of tests, a silicon oxide passivation layer 19 is applied over the counter electrode to form an insulating and protective layer. The counter electrode 16 is approximately 3000 angstroms (300 nm) thick and the protective layer 19 is approximately 5000 angstroms (500 nm) thick. The wires 17 and 18 may be attached with a semiconductor wire bonding machine.

The layers comprising the base electrode 13 are annealed to form a homogeneous polycrystalline grain structure, as will be described below. The counter electrode 16 may be made from the same materials and by the same techniques as the base electrode 13, but this is not essential. For example, if indium is used as one of the superconductors in the base electrode 13, it is not necessary to use indium in the counter electrode 16. Use of indium in the counter electrode could induce current variation under long term storage conditions because it can diffuse into the tunnel barrier 15. The indium that was used in the base electrode 13 in order to supply the proper material for the tunnel barrier 15 is not required in the counter electrode 16.

Figure 2 is a schematic representation of a vacuum bell-jar system 20. The system 20 comprises a base plate 21 with a diffusion pump 22 connected by an aperture 23 in the base plate 21 to the interior of a bell-jar 24. The diffusion pump is provided with a variable orifice adjustment 25. The bell-jar 24 also has an inlet 26 for supplying inert gas to the vacuum chamber under the control of a flow control valve 27. A second inlet 28 and control valve 29 permit the introduction of other gases, such as oxygen, which are used in the process. The base plate 21 carries three thermal evaporation systems 31, 32 and 33, each supporting a tungsten boat, 34, 35 and 36 into which are placed the metals to be evaporated. The boats 34, 35 and 36 are placed as near as possible opposite the substrate described above, which is mounted on a housing 37. It is desirable that the angle theta ($\theta$) at which the metals impinge upon the substrate does not exceed approximately five degrees. The metal housing 37 carries a radio frequency cathode which is employed for radio frequency oxidation of the base electrode 13 to produce the tunnel barrier 15. A stainless steel plate 38 forms the top seal for the bell-jar 24.

In the preferred embodiment process of the present invention, the three tungsten boats 34, 35 and 36 are filled with the metals to be used to form the base electrode 13 and the counter electrode 16. During the complete process described above, they may be left in the vacuum chamber 20 until the Josephson junction 10 is completed. The top plate 38 is opened when necessary to provide access to the substrate 11, 12.

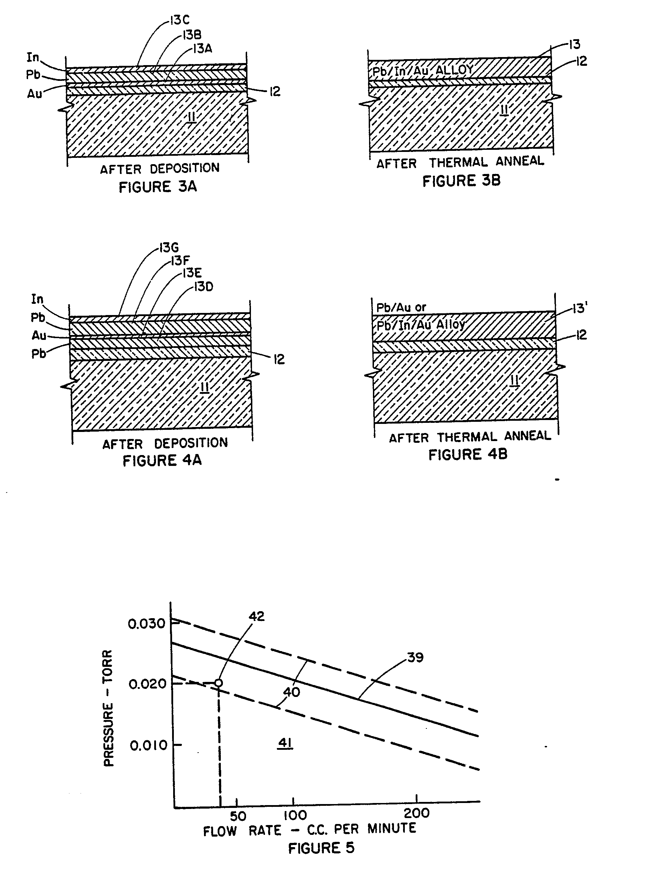

Figure 3A is an enlarged schematic cross-sectional view of a portion of the base electrode material immediately after deposition. The substrate, comprising the silicon wafer 11 and the thermally-grown silicon oxide insulation layer 12, is positioned opposite the tungsten boats 34, 35 and 36, which in this preferred embodiment contain respectively gold, lead and indium. In three successive thermal evaporation steps the gold is first deposited as a layer 13A approximately forty-eight angstroms (4.8 nm) thick. In the next step, a layer of lead 13B is deposited on top of the gold approximately sixteen hundred angstroms (160 nm) thick. Then, on top of the lead layer 13B an indium layer 13C approximately three hundred and fifty angstroms (35 nm) thick is deposited. After the thermal evaporation steps the layers 13A, 13B and 13C may be annealed inside the vacuum chamber using a heater, not shown, within the housing 37, which may comprise coils of tubing within which hot water circulates. Using the heater, the layered structure shown in Figure 3 is annealed at a temperature of sixty degrees centigrade at a partial oxygen pressure of 20 m torr for approximately thirty minutes, producing a homogeneous polycrystalline alloy of lead, indium and gold, as shown in Figure 3B, which at a magnification of 1000× under a microscope, appears smooth and grainless. Examaining the polycrystalline base electrode material 13 under a scanning electron microscope at a magnification of 50,000× reveals that the surface is not completely flat, but has a homogeneous and smoothly undulating surface. At this magnification, it is impossible to distinguish individual grains in the surface of the base electrode material 13. However, it is possible to measure the diameter of the individual undulations and raised shapes, which do not exceed seven hundred and fifty angstroms (75 nm) in diameter.

The same lead-indium-gold alloy base electrode material was applied to a substrate 11, 12 using prior art techniques. Examination of the surface of the prior art base electrode material revealed irregular combined grain-like structures having diameters up to and exceeding five thousand angstroms (500 nm). In the comparison test, the base electrode material 13 was processed at temperatures which exceeded one hundred and twenty-five degrees centigrade for thirty minutes. At the elevated anealing temperature of one hundred and twenty-five degrees centigrade, no observable change was made in the base electrode material made by the method of the present invention. Using the prior art method of producing the base electrode material 13, blisters were easily observed using the 1000× microscope. Thus, it can be concluded that the grain structure of the base electrode material employing the present invention will easily permit process steps at temperatures which exceed seventy-five degrees centigrade without any effect on the stability or growth of the grain size of the base electrode material.

Refer now to Figure 2, 3A and 3B. In the prior art process, the base electrode material was made by pumping the vacuum system 20 down to below $10^{-6}$ torr (1 torr=133 Pa) before depositing the aforementioned layers 13A, 13B and 13C at four degrees centigrade. When this base electrode material was formed as the structure shown in Figure 3A, it was observed that the granular structure was undesirable for use as a Josephson junction electrode. Using the present invention method, the vacuum system 20 was pumped down to below one×$10^{-6}$ torr and before depositing the aforementioned layers 13A, 13B and 13C argon gas was introduced via inlet 26 into the bell-jar 24 to cause the pressure inside the vacuum system 20 to stabilise at 20 m torr. While the inert gas argon was being metered into the vacuum system, the diffusion pump was continuing to stabilise and hold the pressure at approximately 20 m torr. At this increased pressure, the three layers of gold, lead and indium were sequentially evaporatively deposited as layers 13A, 13B and 13C before being annealed at a temperature of approximately sixty degrees centigrade to form the homogeneous polycrystalline fine-grain base electrode material 13. Using the high pressure evaporation technique of this invention, with the presence of inert gas, it was discovered that the grain structure is not only extremely fine and completely consistent, but the layer is substantially, if not completely, immune to damage by thermal cycling between the temperatures of four degrees Kelvin and approximately three hundred degrees Kelvin, which is room temperature.

Four unprotected samples of the base electrode material 13 have been annealed at temperatures much in excess of the standard process temperature of seventy-five degrees centigrade and no ill-effects were observed on the fine-grain polycrystalline material. Further, the samples of the base electrode material were cycled many times at temperatures representative of normal operation of superconductive Josephson junction devices in operational integrated circuits and no grain growth of any type could be observed.

While argon was used as the preferred inert gas in the manufacture of the base electrode material 13, other noble gases such as krypton, xenon, neon and/or helium may be employed in the same manner to produce the same results.

The lead-gold-lead counter electrode 16 may be manufactured by the same techniques as described above. In this case sixteen hundred angstroms (160 nm) of lead are applied on top of the isolation layer 12 and thirty angstroms (3 nm) of gold are applied on top of the first layer of lead. A second layer of lead approximately sixteen hundred angstroms (160 nm) thick would be applied on top of the gold layer and the three layers annealed as described above to produce a homogeneous polycrystalline counter electrode 16. It is preferred, although it may not be essential, to anneal the material layers forming the counter electrode 16 to make it completely homogeneous.

Figures 4A and 4B are an enlarged schematic cross-sectional view immediately after deposition of a portion of the base electrode material 13 employing a different sequence of layers. The substrate 11, 12 is formed as described above and placed on the housing 37 opposite the tungsten boats 34, 35 and 36. After the vacuum chamber 20 has been pumped down to a pressure below one $\times 10^{-6}$ torr, argon gas is introduced via inlet 26 into the bell-jar 24 to cause the pressure inside the vacuum system 20 to stabilise at 20 m torr. The first layer to be deposited on the substrate is of lead 13D, approximately four hundred angstroms (40 nm) thick. On top of layer 13D a layer of gold, 13E, approximately forty-eight angstroms (4.8 nm) thick is deposited. On top of the layer of gold, 13E, a second layer of lead, 13F, approximately twelve hundred angstroms (120 nm) thick is deposited. As a final or top layer, a layer of indium, 13G, approximately three hundred and fifty angstroms (35 nm) thick is deposited. When the four layers 13D to 13G are annealed at approximately sixty degrees centigrade, they inter-diffuse to form a homogeneous polycrystalline fine-grain base electrode material 13', as shown in Figure 4B. It will be noted that the characteristics of the base electrode material 13' may be identical to that shown as material 13 in Figure 3B by employing the proper ratios of material, even though applied to form a layer in a different sequence. If the last and fourth layer 13G of indium is omitted, and the lead-gold-lead layer annealed, there results a preferred counter electrode material 16 which does not have the undesirable long term instability associated with the presence of indium in the counter electrode material.

Other three and four layer combinations of gold and super-conducting materials may be employed to make either the base electrode 13, or the counter electrode 16. For example, lead-gold-lead-tin base electrodes may be made using the same four layer techniques. Further, a single layer of lead-bismuth can be deposited from a single tungsten boat containing the desired alloy, and when deposited at the higher pressure employed in the present invention in the presence of inert gas, forms a more desirable counter electrode material which is not affected by thermal cycling.

Figure 5 is a graph which has as ordinate the pressure of the inert gas inside the vacuum system 20, and as abscissa the flow rate of the gas. The line 39 represents the middle of a range of pressures which in turn determine a desirable range of resistivity of the base electrode material. Below the range 40 it was discovered that the base electrode material was not as tolerant of thermal cycling as material made within the range.

The part of the region 40 below the line 39 represents an area where the resistivity of the base electrode material is approximately three to four times the resistivity of the prior art base electrode material which would be made by employing high vacuum techniques. As the line 39 is approached the new base electrode material 13 made according to the invention has a resistivity approximating to five times the resistivity of the prior art material. It was found that employing a dynamic pressure of 20 m torr and a flow rate of forty cubic centimeters per minute in a particular vacuum chamber a consistent resistivity could be obtained.

The base electrodes made according to the present invention are resistant to thermal cycling, and the material appears to be stable at temperatures up to and including one hundred and twenty-five degrees centigrade, a temperature much higher than those encounted in any process step which would be desired in producing Josephson junctions.

## Claims

1. A method of making a Josephson junction having a base electrode of an alloy comprising lead, gold, and a superconductive metal, the base electrode being deposited by the evaporation in a vacuum chamber of successive layers of the metals the layers then being annealed to allow the metals to diffuse and form a homogeneous polycrystalline alloy layer, characterised in that, in carrying out the said base electrode deposition, the vacuum chamber is first evacuated to a pressure of $1.33 \cdot 10^{-4}$Pa ($10^{-6}$ torr) or less, inert gas is then allowed to flow into the vacuum chamber so as to maintain a pressure within the range 1.33 to 4.00 Pa (10 to 30 m torr), and the deposition of the metal layers is carried out in the inert gas at that pressure.

2. A method according to claim 1 in which the pressure is maintained at 2.67 Pa (20 m torr).

3. A method according to claim 1 or claim 2, in which the inert gas is argon.

4. A method according to any preceding claim in which the super-conductive metal of the base electrode is indium, and the indium layer is deposited last.

## Patentansprüche

1. Verfahren zur Herstellung eines Josephson-Übergangs mit einer Basiselektrode aus einer Blei, Gold und ein supraleitfähiges Metall enthaltenden Legierung, wobei die Basiselektrode durch Verdampfung in einer Vakuumkammer aus aufeinanderfolgenden Schichten der Metalle aufgebracht wird und die Schichten sodann einer Wärmebehandlung unterzogen werden, um die Metalle diffundieren zu lassen und eine homogene polykristalline Legierungsschicht zu bilden, dadurch gekennzeichnet, daß während des Aufbringens der Basiselektrode die Vakuumkammer zunächst auf einen Druck von $1,33 \times 10^{-4}$Pa ($10^{-6}$ Torr) oder weniger evakuiert wird, sodann Inertgas in die Vakuumkammer eingeleitet wird, um einen Druck im Bereich von 1,33 bis 4,00 Pa (10 bis 30 Millitorr) aufrechtzuerhalten, und das Auftragen der Metallschichten in dem Inertgas bei diesem Druck durchgeführt wird.

2. Verfahren nach Anspruch 1, wobei der Druck bei 2,67 Pa (20 Millitorr) gehalten wird.

3. Verfahren nach Anspruch 1 oder 2, wobei das Inertgas Argon ist.

4. Verfahren nach einem der vorhergehenden Ansprüche, wobei das supraleitfähige Metall der Basiselektrode Indium ist und die Indiumschicht zuletzt aufgetragen wird.

## Revendications

1. Procédé de fabrication d'une jonction Josephson comportant une électrode de base en un alliage comprenant du plomb, de l'or et un métal supraconducteur, l'électrode de base étant déposée par l'évaporation, dans une chambre à vide, de couches successives des métaux, couches qui sont ensuite recuites pour permettre aux métaux de diffuser et de former une couche d'alliage polycristallin homogène, caractérisé en ce que lors de l'exécution du dépôt de l'électrode de base, la chambre à vide est tout d'abord mise sous un vide de $1,33 \cdot 10^{-4}$ Pa ($10^{-6}$ torr) ou moins, puis on fait pénétrer un gaz inerte dans la chambre à vide de façon à maintenir une pression dans la gamme de 1,33 à 4,00 Pa (10 à 30 mtorr) et le dépôt des couches des métaux est effectué dans le gaz inerte à cette pression.

2. Procédé selon la revendication 1, dans lequel la pression est maintenue à 2,67 Pa (20 mtorr).

3. Procédé selon la revendication 1 ou 2, dans lequel le gaz inerte est l'argon.

4. Procédé selon l'une quelconque des revendications 1 à 3, dans lequel le métal supraconducteur de l'électrode de base est l'indium, et la couche d'indium est déposée la dernière.

FIGURE 1

FIGURE 2

AFTER DEPOSITION
FIGURE 3A

AFTER THERMAL ANNEAL
FIGURE 3B

AFTER DEPOSITION
FIGURE 4A

AFTER THERMAL ANNEAL
FIGURE 4B

FIGURE 5